(19) Europäisches Patentamt / European Patent Office / Office européen des brevets

(11) **EP 4 032 960 A1**

(12) **EUROPEAN PATENT APPLICATION**
published in accordance with Art. 153(4) EPC

(43) Date of publication:
**27.07.2022 Bulletin 2022/30**

(21) Application number: **20865802.1**

(22) Date of filing: **08.09.2020**

(51) International Patent Classification (IPC):
*C09J 1/00* (2006.01)    *C09J 9/02* (2006.01)
*C22C 13/00* (2006.01)    *C22C 13/02* (2006.01)
*B23K 35/14* (2006.01)    *B23K 35/26* (2006.01)
*H05K 1/14* (2006.01)    *H05K 3/34* (2006.01)
*H05K 3/36* (2006.01)

(52) Cooperative Patent Classification (CPC):
**B23K 35/26; C09J 1/00; C09J 9/02; C22C 13/00; C22C 13/02; H05K 1/14; H05K 3/34; H05K 3/36**

(86) International application number:
**PCT/JP2020/033932**

(87) International publication number:
**WO 2021/054194 (25.03.2021 Gazette 2021/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.09.2019 JP 2019169956**

(71) Applicant: SEKISUI CHEMICAL CO., LTD.
**Osaka-shi**
**Osaka**
**530-8565 (JP)**

(72) Inventors:
• **HASEGAWA, Atsushi**
**Kouka-shi, Shiga 528-8585 (JP)**
• **MATSUSHITA, Kiyoto**
**Mishima-gun, Osaka 618-0021 (JP)**

(74) Representative: **Ter Meer Steinmeister & Partner**
**Patentanwälte mbB**
**Nymphenburger Straße 4**
**80335 München (DE)**

(54) **ADHESIVE AND ANTENNA DEVICE**

(57)    Provided is a bonding material capable of controlling a gap of an air cavity with high accuracy even when the bonding material is repeatedly heated. The bonding material according to the present invention is a bonding material for bonding metals to each other between a first substrate having the first metal portion on its surface and a second substrate having the second metal portion on its surface, and a rate of change in gap between the substrates calculated by the following Evaluation Test 1a is 10% or less. Evaluation Test 1a: the bonding material is disposed on the first metal portion of the first substrate, and the second substrate having the second metal portion is disposed on a surface of the bonding material opposite to a side of the first substrate such that the first metal portion and the second metal portion face each other. Thereafter, the first substrate and the second substrate are bonded by reflow treatment to obtain a laminate. The obtained laminate is subjected to reflow treatment four times. From the gaps before and after heating, the rate of change in gap is calculated.

[FIG. 3.]

Description

**TECHNICAL FIELD**

The present invention relates to a bonding material for bonding two substrates. The present invention also relates to an antenna device using the bonding material.

**BACKGROUND ART**

Various bonding materials are used for bonding two adherends. In order to make a thickness of a bonding layer formed by the bonding material uniform and to control an interval (gap) between the two adherends, a spacer such as a gap material may be blended in the bonding material.

In recent years, with a rapid spread of smartphones, tablet terminals, and the like, a rapid increase in traffic has been a problem. For this reason, a fifth generation mobile communication system (5G) has been studied as a successor system of a communication system such as LTE (Long Term Evolution) or LTE-A (LTE-Advanced) by 3GPP (Third Generation Partnership Project) or a new wireless communication system.

For example, in the fifth generation mobile communication system (5G), in order to achieve high-speed transmission using a wider band, it is considered to perform communication using a higher carrier frequency than LTE and LTE-A. However, when communication is performed at a high carrier frequency, there is a possibility that a conventional antenna device cannot sufficiently exhibit performance. The conventional antenna device is disclosed in, for example, Patent Document 1 below.

Patent Document 1 below discloses an antenna device including an antenna and a multilayer high frequency substrate. The antenna includes a feeding conductor on the back surface. The multilayer high frequency substrate is configured by stacking a plurality of strip lines including a land on its surface. The land is electrically connected to a strip conductor via a through hole. In the multilayer high frequency substrate, the lands of the strip lines to be stacked are joined with an anisotropic conductive bonding material. In the antenna device, the feeding conductor of the antenna and the land on the surface of the multilayer high frequency substrate are joined by an anisotropic conductive bonding material.

**Related Art Document**

**Patent Document**

Patent Document 1: JP 2015-185550 A

**SUMMARY OF THE INVENTION**

**PROBLEMS TO BE SOLVED BY THE INVENTION**

In antennas of a base station and a terminal for the fifth generation mobile communication system (5G), improvement in communication speed, improvement in communication quality, and the like are required. In order to achieve improvement in communication speed, improvement in communication quality, and the like, it has been studied to provide an air cavity (space) in an antenna. By providing the air cavity (space) in the antenna, a bandwidth can be improved, and electromagnetic wave noise can be reduced. As a result, the communication speed, the communication quality, and the like of the antenna can be improved.

In the conventional antenna device, a high level of communication speed and a high level of communication quality are not required, and the air cavity (space) may not be provided in the antenna. The air cavity (space) is formed, for example, by keeping uniform and constant an interval (gap) between a high frequency substrate and a substrate constituting the antenna. In order to improve the communication speed, the communication quality, and the like of the antenna, it is required to control the interval (gap) of the air cavity (space) with high accuracy.

When the antenna device is obtained by bonding two substrates using a bonding material so as to form an air cavity (space) in the antenna, the antenna device may be repeatedly heated. Since the antenna device is repeatedly heated, the interval (gap) of the air cavity (space) cannot be controlled with high accuracy, and it may be difficult to improve the communication speed, the communication quality, and the like of the antenna.

An object of the present invention is to provide a bonding material capable of controlling the gap of the air cavity with high accuracy even when the bonding material is repeatedly heated. It is also an object of the present invention to provide an antenna device using the bonding material.

**MEANS FOR SOLVING THE PROBLEMS**

According to a broad aspect of the present invention, there is provided a bonding material for bonding a first metal portion and a second metal portion to each other between a first substrate having the first metal portion on its surface and a second substrate having the second metal portion on its surface, in which a rate of change in gap between the substrates calculated by the following Evaluation Test 1a is 10% or less.

Evaluation Test 1a:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. The gap between the substrates of the obtained laminate is measured and taken as the gap before heating. Thereafter, the obtained laminate is subjected to reflow treatment four times under reflow conditions defined in JEDEC J-STD-020, and the gap between the substrates of the laminate after reflow treatment is measured and taken as the gap after heating. From the gaps before and after heating, the rate of change in gap is calculated by the following Equation (1).

$$\text{Rate of Change in Gap} = [(\text{Gap before Heating} - \text{Gap after Heating})/\text{Gap before Heating}] \times 100 \quad \text{Equation (1)}$$

In a specific aspect of the bonding material according to the present invention, the bonding material contains metal particles.
According to a broad aspect of the present invention, there is provided a bonding material for bonding a first metal portion and a second metal portion to each other between a first substrate having the first metal portion on its surface and a second substrate having the second metal portion on its surface, in which the bonding material contains metal particles, and a ratio of a gap after heating calculated by the following Evaluation Test 1b to an average particle diameter of the metal particles is 0.70 or more and 0.97 or less.

Evaluation Test 1b:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. The obtained laminate is subjected to reflow treatment four times under reflow conditions defined in JEDEC J-STD-020, and the gap between the substrates of the laminate after reflow treatment is measured and taken as the gap after heating.
In a specific aspect of the bonding material according to the present invention, the metal particle includes a base particle and a metal layer disposed on a surface of the base particle.
In a specific aspect of the bonding material according to the present invention, the metal layer includes a second metal layer disposed on a surface of the base particle and a first metal layer disposed on a surface of the second metal layer, and the first metal layer is a solder layer.
In a specific aspect of the bonding material according to the present invention, a rate of change in bonding strength between the substrates calculated by the following Evaluation Test 2 is 10% or less.

Evaluation Test 2:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. Using the obtained laminate, the bonding strength between the substrates is measured under conditions conforming to MIL STD-883G, and taken as the bonding strength before heating. Thereafter, the obtained laminate is subjected to reflow treatment four times under reflow conditions defined in JEDEC J-STD-020, and the bonding strength between the substrates is measured using the laminate after reflow treatment under conditions conforming to MIL STD-883G, and taken as the bonding strength after heating. From the bonding strength before and after heating, the rate of change in bonding strength is calculated by the following Equation (2).

$$\text{Rate of Change in Bonding Strength} = [(\text{Bonding Strength before Heating} - \text{Bonding Strength after Heating})/\text{Bonding Strength before Heating}] \times 100 \quad \text{Equation (2)}$$

In a specific aspect of the bonding material according to the present invention, the first substrate is a glass epoxy substrate or a ceramic substrate, and the second substrate is a glass epoxy substrate, a ceramic substrate, or a silicon substrate.

In a specific aspect of the bonding material according to the present invention, the first metal portion is formed of copper or formed by nickel/gold plating, and the second metal portion is formed of copper or formed by nickel/gold plating.

According to a broad aspect of the present invention, there is provided an antenna device including: a first substrate having a first metal portion on its surface; a second substrate having a second metal portion on its surface; and a bonding material portion that bonds the first substrate and the second substrate to each other, in which a material of the bonding material portion is the above-described bonding material, the first metal portion and the second metal portion are bonded to each other by the bonding material portion, and an air cavity is formed by the first substrate, the second substrate, and the bonding material portion.

In a specific aspect of the antenna device according to the present invention, the first substrate is a glass epoxy substrate or a ceramic substrate, and the second substrate is a glass epoxy substrate, a ceramic substrate, or a silicon substrate.

In a specific aspect of the antenna device according to the present invention, the first metal portion is formed of copper or formed by nickel/gold plating, and the second metal portion is formed of copper or formed by nickel/gold plating.

**EFFECT OF THE INVENTION**

The bonding material according to the present invention is a bonding material for bonding a first metal portion and a second metal portion to each other between a first substrate having the first metal portion on its surface and a second substrate having the second metal portion on its surface. In the bonding material according to the present invention, the rate of change in gap between the substrates calculated by the Evaluation Test 1a is 10% or less. Since the bonding material according to the present invention has the above-described configuration, the gap of the air cavity can be controlled with high accuracy even when the bonding material is repeatedly heated.

The bonding material according to the present invention is a bonding material for bonding a first metal portion and a second metal portion to each other between a first substrate having the first metal portion on its surface and a second substrate having the second metal portion on its surface. The bonding material according to the present invention contains metal particles. In the bonding material according to the present invention, the ratio of the gap after heating calculated by the Evaluation Test 1b to the average particle diameter of the metal particles is 0.70 or more and 0.97 or less. Since the bonding material according to the present invention has the above-described configuration, the gap of the air cavity can be controlled with high accuracy even when the bonding material is repeatedly heated.

**BRIEF DESCRIPTION OF DRAWINGS**

[Fig. 1] Fig. 1 is a cross-sectional view showing a first example of a metal particle usable for a bonding material according to one embodiment of the present invention.

[Fig. 2] Fig. 2 is a cross-sectional view showing a second example of the metal particle usable for the bonding material according to one embodiment of the present invention.

[Fig. 3] Fig. 3 is a cross-sectional view showing an example of an antenna device using the bonding material according to the present invention.

[Fig. 4] Fig. 4 is an enlarged cross-sectional view showing a bonding portion between the metal particle and a metal portion in the antenna device shown in Fig. 3.

**MODE(S) FOR CARRYING OUT THE INVENTION**

Hereinafter, the details of the present invention will be described.

(Bonding material)

The bonding material according to the present invention is a bonding material for bonding a first metal portion and a second metal portion to each other between a first substrate having the first metal portion on its surface and a second substrate having the second metal portion on its surface. In the bonding material according to the present invention, the rate of change in gap between the substrates calculated by the following Evaluation Test 1a is 10% or less.

Evaluation Test 1a:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. The gap between the substrates of the obtained laminate is measured and taken as the gap before heating. That is, the gap before heating means the gap before the laminate is heated. Thereafter, the obtained laminate is subjected to reflow treatment four times under reflow conditions defined in JEDEC J-STD-020, and the gap between the substrates of the laminate after reflow treatment is measured and taken as the gap after heating. That is, the gap after heating means the gap after the laminate is heated four times. From the gaps before and after heating, the rate of change in gap is calculated by the following Equation (1).

$$\text{Rate of Change in Gap} = [(\text{Gap before Heating} - \text{Gap after Heating})/\text{Gap before Heating}] \times 100 \quad \text{Equation (1)}$$

In the Evaluation Test 1a, it is preferable that the bonding material is disposed so that the gap before heating is 60 $\mu$m or more, and it is preferable that the bonding material is disposed so that the gap before heating is 850 $\mu$m or less.

The bonding material according to the present invention is a bonding material for bonding a first metal portion and a second metal portion to each other between a first substrate having the first metal portion on its surface and a second substrate having the second metal portion on its surface. The bonding material according to the present invention contains metal particles. In the bonding material according to the present invention, the ratio of the gap after heating calculated by the following Evaluation Test 1b to the average particle diameter of the metal particles is 0.70 or more and 0.97 or less.

Evaluation Test 1b:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. The obtained laminate is subjected to reflow treatment four times under reflow conditions defined in JEDEC J-STD-020, and the gap between the substrates of the laminate after reflow treatment is measured and taken as the gap after heating.

In the Evaluation Test 1b, it is preferable that the bonding material is disposed so that the gap between the substrates of the laminate (laminate before reflow treatment) is 60 $\mu$m or more, and it is preferable that the bonding material is disposed so that the gap is 850 $\mu$m or less.

Since the bonding material according to the present invention has the above-described configuration, the gap of the air cavity can be controlled with high accuracy even when the bonding material is repeatedly heated.

When the antenna device is obtained by bonding two substrates using a bonding material so as to form an air cavity (space) in the antenna, the antenna device may be repeatedly heated. In the antenna device obtained using a conventional bonding material, since the antenna device is repeatedly heated, the interval (gap) of the air cavity (space) cannot be controlled with high accuracy, and it may be difficult to improve the communication speed, the communication quality, and the like of the antenna.

On the other hand, since the bonding material according to the present invention has the above-described configuration, the gap between the substrates can be controlled with high accuracy even when the bonding material is repeatedly heated, and the gap of the air cavity can be controlled with high accuracy. As a result, the communication speed, the communication quality, and the like of the antenna can be further improved.

The bonding material according to the present invention is a bonding material for bonding a first metal portion and a second metal portion to each other between a first substrate having the first metal portion on its surface and a second substrate having the second metal portion on its surface. The bonding material according to the present invention is a bonding material for bonding two substrates. The bonding material according to the present invention is preferably a bonding material for bonding metal portions in two substrates to each other.

In the bonding material according to the present invention, the rate of change in gap between the substrates calculated by the Evaluation Test 1a is 10% or less. The rate of change in gap between the substrates calculated by the Evaluation Test 1a is preferably 5% or less, more preferably 3% or less. When the rate of change in gap between the substrates calculated by the Evaluation Test 1a is equal to or less than the above upper limit, the gap of the air cavity can be controlled with high accuracy even in the case of repeated heating.

In the bonding material according to the present invention, the ratio of the gap after heating calculated by the Evaluation Test 1b to the average particle diameter of the metal particles (the gap after heating calculated by the Evaluation Test 1b/the average particle diameter of the metal particles) is 0.70 or more and 0.97 or less. The ratio (the gap after heating calculated by the Evaluation Test 1b/the average particle diameter of the metal particles) is preferably 0.75 or more, more preferably 0.80 or more, and preferably 0.95 or less, more preferably 0.90 or less. When the ratio (the gap after heating calculated by the Evaluation Test 1b/the average particle diameter of the metal particles) is equal to or more than the above lower limit and equal to or less than the above upper limit, the gap of the air cavity can be controlled with high accuracy even in the case of repeated heating.

In the bonding material, the rate of change in bonding strength between the substrates calculated by the following Evaluation Test 2 is preferably 10% or less, more preferably 5% or less, still more preferably 3% or less When the rate of change in bonding strength between the substrates calculated by the following Evaluation Test 2 is equal to or less than the above upper limit, the bonding strength between the substrates can be maintained even in the case of repeated heating, and the gap of the air cavity can be controlled with high accuracy.

Evaluation Test 2:

The first substrate having the first metal portion on the surface, the second substrate having the second metal portion on the surface, and the bonding material are provided. The bonding material is disposed on the first metal portion of the first substrate, and the second substrate is disposed on a surface of the bonding material opposite to a side of the first substrate such that the first metal portion and the second metal portion face each other. Thereafter, the first substrate and the second substrate are bonded to each other by performing reflow treatment under reflow conditions defined in JEDEC J-STD-020 to obtain a laminate. Using the obtained laminate, the bonding strength between the substrates is measured under conditions conforming to MIL STD-883G, and taken as the bonding strength before heating. Thereafter, the obtained laminate is subjected to reflow treatment four times under reflow conditions defined in JEDEC J-STD-020, and the bonding strength between the substrates is measured using the laminate after reflow treatment under conditions conforming to MIL STD-883G, and taken as the bonding strength after heating. From the bonding strength before and after heating, the rate of change in bonding strength is calculated by the following Equation (2).

$$\text{Rate of Change in Bonding Strength} = [(\text{Bonding Strength before Heating} - \text{Bonding Strength after Heating})/\text{Bonding Strength before Heating}] \times 100 \quad \text{Equation (2)}$$

In the Evaluation Test 2, it is preferable that the bonding material is disposed so that the gap between the substrates of the laminate (laminate before reflow treatment) is 60 $\mu$m or more, and it is preferable that the bonding material is disposed so that the gap is 850 $\mu$m or less.

In the Evaluation Test 2, the bonding strength before heating is preferably 1.5 kgf or more, and more preferably 2.0 kgf or more. When the bonding strength before heating is equal to or more than the above lower limit, the bonding strength between the substrates can be maintained even in the case of repeated heating, and the gap of the air cavity can be controlled with high accuracy.

In the Evaluation Test 1a, the Evaluation Test 1b, and the Evaluation Test 2, the first substrate is preferably a glass epoxy substrate or a ceramic substrate. In the Evaluation Test 1a, the Evaluation Test 1b, and the Evaluation Test 2, the second substrate is preferably a glass epoxy substrate, a ceramic substrate, or a silicon substrate.

In the Evaluation Test 1a, the Evaluation Test 1b, and the Evaluation Test 2, the first metal portion is preferably formed of copper or formed by nickel/gold plating. In the Evaluation Test 1a, the Evaluation Test 1b, and the Evaluation Test 2, the second metal portion is preferably formed of copper or formed by nickel/gold plating.

The Evaluation Test 1a, the Evaluation Test 1b, and the Evaluation Test 2 are performed in order to calculate the rate of change in gap, the ratio (the gap after heating calculated by the Evaluation Test 1b/the average particle diameter of the metal particles), and the rate of change in bonding strength. When the bonding material is actually used, the bonding material may not be treated under the conditions defined in the Evaluation Test 1a, the Evaluation Test 1b, and the Evaluation Test 2. For example, when the bonding material is actually used, reflow treatment may not be performed under the reflow conditions defined in JEDEC J-STD-020.

The bonding material preferably contains metal particles from the viewpoint of controlling the gap of the air cavity with high accuracy even when the bonding material is repeatedly heated. The bonding material may or may not contain components other than the metal particles. From the viewpoint of controlling the gap of the air cavity with higher accuracy even when the bonding material is repeatedly heated, the bonding material preferably contains only the metal particles, and is preferably a particle group of a plurality of metal particles.

The bonding material can bond two adherends, for example. The adherend is preferably a substrate, and more preferably a substrate having a metal portion on its surface. The bonding material is preferably used for bonding two substrates. The bonding material is preferably used for bonding the two metal portions to each other. Furthermore, the bonding material is preferably used for controlling the gap between the two substrates. The bonding material is preferably used for controlling the gap between the two substrates.

The bonding material may be used for conductive connection or may not be used for conductive connection. The bonding material is preferably used for the antenna device. The bonding material is preferably used for forming an air cavity. The bonding material is preferably used for forming an air cavity in the antenna device. In the antenna device, the bonding material is preferably used for keeping uniform and constant an interval (gap) between a high frequency substrate and a substrate constituting the antenna. The bonding material forms an air cavity in the antenna device, and is preferably used for improving the communication speed, the communication quality, and the like of the antenna.

(Metal particle)

The bonding material according to the present invention preferably contains metal particles. The metal particle means a particle containing a metal. The metal particle may have a constituent component other than metal. The metal particle preferably has, for example, a role of regulating an interval (gap) between two substrates. The metal particle is preferably not a solder particle formed only of solder. The metal particle preferably includes a base particle and a metal layer disposed on a surface of the base particle. The metal layer may have a single layer structure or a multilayer structure of two or more layers.

The metal particle preferably has solder on an outer surface portion of the metal layer. The base particle is preferably not the solder particle formed only of solder. When the metal particle is a solder particle in which both a center portion and the outer surface portion of the metal layer are formed of solder, it may be difficult to control the gap of the air cavity because the solder wets and spreads due to heating in the case of repeated heating. When the metal particle is a metal particle having a base particle not formed of solder and a metal layer (solder layer) disposed on the surface of the base particle, excessive wetting and spreading of the solder due to heating can be suppressed even in the case of repeated heating, and therefore, the gap of the air cavity can be controlled with high accuracy. Accordingly, the metal particle is preferably not a solder particle formed of solder. In the metal particle, both the center portion and the outer surface portion of the metal layer are preferably not a solder particle formed of solder.

The average particle diameter of the metal particles is not particularly limited. The average particle diameter of the metal particles can be appropriately selected according to a gap of a target air cavity. The average particle diameter of the metal particles may be, for example, 80 μm or more and 900 μm or less.

The average particle diameter of the metal particles is preferably a number average particle diameter. The average particle diameter of the metal particles is determined by, for example, observing arbitrary 50 metal particles with an electron microscope or an optical microscope, and calculating an average value of the particle diameter of each metal particle or performing laser diffraction type particle size distribution measurement. In the observation with the electron microscope or the optical microscope, the particle diameter of the metal particle per particle is determined as a particle diameter corresponding to an equivalent circle diameter. In the observation with the electron microscope or the optical microscope, the average particle diameter obtained from the equivalent circle diameters of arbitrary 50 metal particles is substantially equal to the average particle diameter corresponding to an equivalent sphere diameter. In the laser diffraction type particle size distribution measurement, the particle diameter of the metal particle per particle is determined as a particle diameter corresponding to an equivalent sphere diameter.

A variation coefficient (CV value) of the particle diameter of the metal particles is preferably 10% or less, more preferably 5% or less. When the variation coefficient of the particle diameter of the metal particle is equal to or less than the upper limit, the gap of the air cavity can be controlled with higher accuracy.

The variation coefficient (CV value) can be measured as follows.

$$CV\ value\ (\%) = (\rho/Dn) \times 100$$

$\rho$: standard deviation of particle diameter of metal particle
Dn: average value of particle diameter of metal particle

The shape of the metal particles is not particularly limited. The shape of the metal particle may be a spherical shape, a shape other than a spherical shape, or a shape such as a flat shape.

Next, specific examples of the metal particles will be described with reference to the drawings.

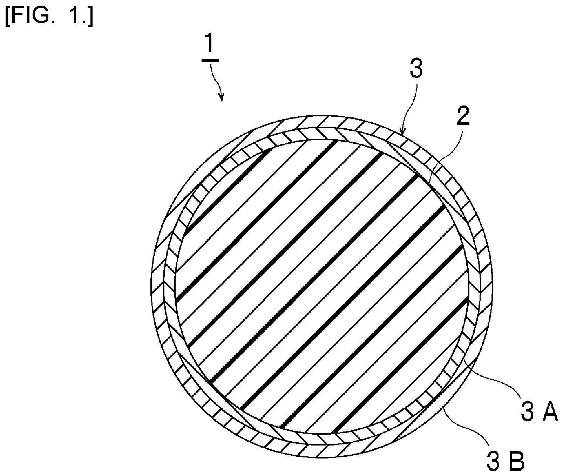

Fig. 1 is a cross-sectional view showing a first example of the metal particle usable for the bonding material according to one embodiment of the present invention.

A metal particle 1 shown in Fig. 1 includes a base particle 2 and a metal layer 3 disposed on a surface of the base particle 2. The metal layer 3 covers the surface of the base particle 2. The metal particle 1 is a covered particle in which the surface of the base particle 2 is covered with the metal layer 3.

The metal layer 3 includes a second metal layer 3A and a solder layer 3B (first metal layer). The metal particle 1 includes the second metal layer 3A between the base particle 2 and the solder layer 3B. Accordingly, the metal particle 1 includes the base particle 2, the second metal layer 3A disposed on the surface of the base particle 2, and the solder layer 3B disposed on an outer surface of the second metal layer 3A. As described above, the metal layer 3 may have a multilayer structure of two or more layers, or may have a multilayer structure.

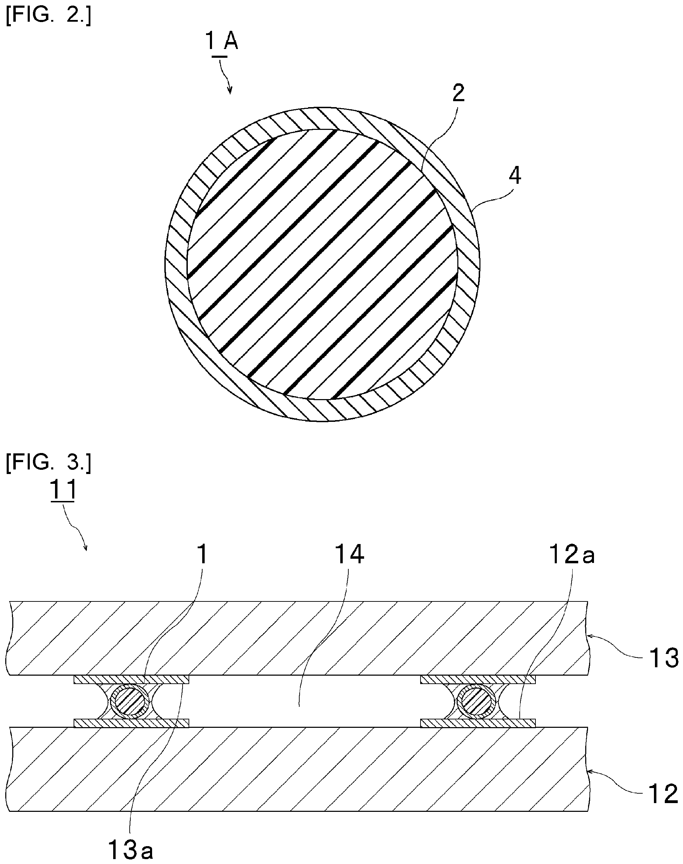

Fig. 2 is a cross-sectional view showing a second example of the metal particle usable for the bonding material according to one embodiment of the present invention.

The metal layer 3 of the metal particle 1 in Fig. 1 has a two-layer structure. A metal particle 1A shown in Fig. 2 has a solder layer 4 as a single-layer metal layer. The metal particle 1A includes the base particle 2 and the solder layer 4 disposed on the surface of the base particle 2.

Hereinafter, other details of the metal particle will be described.

Base particle:

Examples of the base particle include resin particles, inorganic particles excluding metal-containing particles, organic-inorganic hybrid particles, and metal-containing particles. The base particle is preferably a base particle excluding a metal-containing particle, and is preferably a resin particle, an inorganic particle excluding a metal-containing particle, or an organic-inorganic hybrid particle. The base particle may be a core-shell particle including a core and a shell disposed on a surface of the core. The core may be an organic core, and the shell may be an inorganic shell.

Various organic substances are suitably used as a material of the resin particle. Examples of the material of the resin particle include polyolefin resins such as polyethylene, polypropylene, polystyrene, polyvinyl chloride, polyvinylidene chloride, polyisobutylene, and polybutadiene; acrylic resins such as polymethyl methacrylate and polymethyl acrylate; polycarbonate, polyamide, phenol formaldehyde resin, melamine formaldehyde resin, benzoguanamine formaldehyde resin, urea formaldehyde resin, phenol resin, melamine resin, benzoguanamine resin, urea resin, epoxy resin, unsaturated polyester resin, saturated polyester resin, polyethylene terephthalate, polysulfone, polyphenylene oxide, polyacetal, polyimide, polyamideimide, polyether ether ketone, polyether sulfone, divinylbenzene polymer, and divinylbenzene-based copolymer. Examples of the divinylbenzene-based copolymer include divinylbenzene-styrene copolymer and divinylbenzene-(meth)acrylate copolymer. Since the hardness of the resin particle can be easily controlled within a preferable range, the material of the resin particle is preferably a polymer obtained by polymerizing one or more polymerizable monomers having an ethylenically unsaturated group.

When the resin particle is obtained by polymerizing a polymerizable monomer having an ethylenically unsaturated group, examples of the polymerizable monomer having the ethylenically unsaturated group include non-crosslinkable monomers and crosslinkable monomers.

Examples of the non-crosslinkable monomers include styrene-based monomers such as styrene and $\alpha$-methylstyrene; carboxyl group-containing monomers such as (meth)acrylic acid, maleic acid, and maleic anhydride; alkyl (meth)acrylate compounds such as methyl (meth)acrylate, ethyl (meth)acrylate, propyl (meth)acrylate, butyl (meth)acrylate, 2-ethyl hexyl (meth)acrylate, lauryl (meth)acrylate, cetyl (meth)acrylate, stearyl (meth)acrylate, and isobornyl (meth)acrylate; oxygen atom-containing (meth)acrylate compounds such as 2-hydroxyethyl (meth)acrylate, glycerol (meth)acrylate, polyoxyethylene (meth)acrylate, and glycidyl (meth)acrylate; nitrile-containing monomers such as (meth)acrylonitrile; vinyl ether compounds such as methyl vinyl ether, ethyl vinyl ether, and propyl vinyl ether; acid vinyl ester compounds such as vinyl acetate, vinyl butyrate, vinyl laurate, and vinyl stearate; unsaturated hydrocarbons such as ethylene, propylene, isoprene, and butadiene; and halogen-containing monomers such as trifluoromethyl (meth)acrylate, pentafluoroethyl (meth)acrylate, vinyl chloride, vinyl fluoride, and chlorostyrene.

Examples of the crosslinkable monomers include polyfunctional (meth)acrylate compounds such as tetramethylolmethane tetra(meth)acrylate, tetramethylolmethane tri(meth)acrylate, tetramethylolmethane di(meth)acrylate, trimethylolpropane tri(meth)acrylate, dipentaerythritol hexa(meth)acrylate, dipentaerythritol penta(meth)acrylate, glycerol tri(meth)acrylate, glycerol di(meth)acrylate, (poly)ethylene glycol di(meth)acrylate, (poly)propylene glycol di(meth)acrylate, (poly)tetramethylene glycol di(meth)acrylate, and 1,4-butanediol di(meth)acrylate; and silane-containing monomers such as triallyl (iso)cyanurate, triallyl trimellitate, divinylbenzene, diallyl phthalate, diallyl acrylamide, diallyl ether, and $\gamma$-(meth)acryloxy propyl trimethoxy silane, trimethoxy silyl styrene, and vinyltrimethoxysilane.

The term "(meth)acrylate" refers to an acrylate and a methacrylate. The term "(meth)acrylic" refers to an acrylic and a methacrylic. The term "(meth)acryloyl" refers to an acryloyl and a methacryloyl.

The resin particle can be obtained by polymerizing the polymerizable monomer having an ethylenically unsaturated group by a known method. Examples of this method include a method of suspension polymerization in the presence of a radical polymerization initiator, and a method of swelling and polymerizing monomers together with a radical polymerization initiator using non-crosslinked seed particles.

When the base particle is an inorganic particle excluding a metal-containing particle or an organic-inorganic hybrid particle, examples of the inorganic substance for forming the base particle include silica, alumina, barium titanate, zirconia, and carbon black. It is preferable that the inorganic substance is not a metal. The particles formed of the silica are not particularly limited, and examples thereof include particles obtained by hydrolyzing a silicon compound having two or more hydrolyzable alkoxysilyl groups to form crosslinked polymer particles and then performing firing as necessary. Examples of the organic-inorganic hybrid particles include organic-inorganic hybrid particles formed of crosslinked alkoxysilyl polymer and an acrylic resin.

The organic-inorganic hybrid particle is preferably a core-shell type organic-inorganic hybrid particle having a core and a shell disposed on the surface of the core. The core is preferably an organic core. The shell is preferably an inorganic shell. From the viewpoint of more effectively lowering connection resistance between the electrodes, the base particle is preferably an organic-inorganic hybrid particle having an organic core and an inorganic shell disposed on the surface of the organic core.

Examples of the material of the organic core include the material of the resin particle described above.

Examples of the material of the inorganic shell include the inorganic substances exemplified as the material of the base particle described above. The material of the inorganic shell is preferably silica. It is preferable that the inorganic shell is formed by forming metal alkoxide into a shell-like material on the surface of the core by a sol-gel method and then firing the shell-like material. The metal alkoxide is preferably a silane alkoxide. It is preferable that the inorganic shell is formed of a silane alkoxide.

When the base particle is a metal-containing particle, examples of the metal as the material of the metal-containing particle include silver, copper, nickel, silicon, gold and titanium.

The particle diameter of the base particle is not particularly limited. The particle diameter of the base particle can be appropriately selected according to a gap of a target air cavity. The particle diameter of the base particle may be, for example, 80 $\mu$m or more and 900 $\mu$m or less.

The particle diameter of the base particle indicates the diameter when the base particle has a spherical shape, and indicates an equivalent sphere diameter when the base particle does not have a spherical shape.

The particle diameter of the base particle is preferably a number average particle diameter. The particle diameter of the base particle is determined using a particle size distribution measuring device or the like. The particle diameter of the base particle is preferably determined by observing arbitrary 50 base particles with an electron microscope or an optical microscope and calculating an average value. In the observation with the electron microscope or the optical microscope, the particle diameter of the base particle per particle is determined as a particle diameter corresponding to an equivalent circle diameter. In the observation with the electron microscope or the optical microscope, the average particle diameter obtained from the equivalent circle diameters of arbitrary 50 base particles is substantially equal to the average particle diameter corresponding to an equivalent sphere diameter. In the laser diffraction type particle size distribution measurement, the particle diameter of the base particle per particle is determined as a particle diameter corresponding to an equivalent sphere diameter.

Metal layer:

The metal particle preferably includes a base particle and a metal layer disposed on a surface of the base particle. The metal layer may have a single layer structure or a multilayer structure of two or more layers. When the metal layer has a multilayer structure of two or more layers, the metal particle preferably includes a base particle, a second metal layer disposed on a surface of the base particle, and a solder layer (first metal layer) disposed on a surface of the second metal layer. The metal particle preferably has solder on an outer surface portion of the metal layer.

The metal layer includes a metal. The metal constituting the metal layer is not particularly limited. Examples of the metal include gold, silver, copper, platinum, palladium, zinc, lead, aluminum, cobalt, indium, nickel, chromium, titanium, antimony, bismuth, germanium, cadmium, and alloys of these. As the metal, tin-doped indium oxide (ITO) and solder may be used. One kind of the metal may be used alone, and two or more kinds thereof may be used in combination. From the viewpoint of controlling the gap of the air cavity with higher accuracy and further increasing the bonding strength between the substrates, the metal contained in the metal layer as the outermost layer is preferably solder.

The melting point of the base particle is preferably higher than the melting point of the metal layer. The melting point of the base particle is preferably more than 160°C, more preferably more than 300°C, still more preferably more than 400°C, particularly preferably more than 450°C. The melting point of the base particle may be less than 400°C. The melting point of the base particle may be 160°C or less. The softening point of the base particle is preferably 260°C or more. The softening point of the base particle may be less than 260°C.

The metal particle may have a single layer solder layer. The metal particle may have a plurality of metal layers (a second metal layer and a solder layer (first metal layer)). That is, in the metal particle, two or more metal layers may be stacked. When two or more metal layers are stacked, the metal particle preferably has solder on the outer surface portion of the metal layer.

The solder is preferably a metal (low melting point metal) having a melting point of 450°C or less. The solder layer is preferably a metal layer (low melting point metal layer) having a melting point of 450°C or less. The low melting point metal layer is a layer containing a low melting point metal. The solder in the metal particle is preferably a metal (low melting point metal) having a melting point of 450°C or less. The low melting point metal indicates a metal having a melting point of 450°C or less. The melting point of the low melting point metal is preferably 300°C or less, more preferably 220°C or less.

The melting point of the low melting point metal can be determined by differential scanning calorimetry (DSC). Examples of a differential scanning calorimetry (DSC) device include "EXSTAR DSC 7020" manufactured by Seiko Instruments Inc.

The solder in the metal particle preferably contains tin. The content of tin in 100% by weight of metal contained in the solder in the metal particle is preferably 30% by weight or more, more preferably 40% by weight or more, still more preferably 70% by weight or more, particularly preferably 90% by weight or more. When the content of tin contained in the solder in the metal particle is equal to or more than the above lower limit, the bonding strength between the substrates can be further enhanced.

The content of tin can be measured by using a highfrequency induction coupling plasma emission spectrometry apparatus ("ICP-AES" manufactured by Horiba, Ltd.), a fluorescence X-ray analyzing apparatus ("EDX-800HS" manufactured by Shimadzu Corporation), or the like.

When the bonding material containing metal particles having the solder on the outer surface portion of the metal layer is used for bonding the metal portions formed on the two substrates to each other, the solder can be melted to be joined to the metal portion. For example, since the solder and the metal portion are easily brought into surface contact rather than point contact, the bonding strength between the substrates can be further enhanced, and a contact area between the metal particles and the metal portion can be sufficiently increased.

The low melting point metal constituting the solder layer and the solder in the metal particle is not particularly limited. The low melting point metal is preferably tin or an alloy containing tin. Examples of the alloy include tin-silver alloy, tin-copper alloy, tin-silver-copper alloy, tin-bismuth alloy, tin-zinc alloy, and tin-indium alloy. Among these, the low melting point metal is preferably tin, tin-silver alloy, tin-silver-copper alloy, tin-bismuth alloy, or tin-indium alloy because of being excellent in wettability to the metal portion.

The material for forming the solder layer and the solder in the metal particle is preferably a filler material having a liquidus line of 450°C or lower in accordance with JIS Z3001: Welding Terms. Examples of the composition of the solder include metallic compositions including zinc, gold, silver, lead, copper, tin, bismuth and indium.

In order to further increase joint strength between the solder in the metal particle and the metal portion, the solder in the metal particle may contain a metal such as nickel, copper, antimony, aluminum, zinc, iron, gold, titanium, phosphorus, germanium, tellurium, cobalt, bismuth, manganese, chromium, molybdenum, or palladium. From the viewpoint of further increasing the bonding strength between the solder in the metal particle and the metal portion, the solder in the metal particle preferably contains nickel, copper, or antimony. From the viewpoint of further increasing the bonding strength between the solder in the metal particle and the metal portion, the content of these metals for increasing the bonding strength is preferably 0.001% by weight or more and preferably 1% by weight or less in 100% by weight of the solder in the metal particle.

When the metal particle preferably includes a base particle, a second metal layer disposed on a surface of the base particle, and a solder layer disposed on a surface of the second metal layer.

The melting point of the second metal layer is preferably higher than the melting point of the solder layer. The melting point of the second metal layer is preferably more than 220°C, more preferably more than 300°C, still more preferably more than 400°C, even more preferably more than 450°C, particularly preferably more than 500°C, most preferably more than 600°C. Since the solder layer has a low melting point, it is preferable that the solder layer is melted when an air cavity is formed. The second metal layer is preferably not melted when the air cavity is formed. It is preferable that the metal particle is used by melting the solder, it is preferable that the metal particle is used by melting the solder layer, and it is preferable that the metal particle is used by melting the solder layer without melting the second metal layer. Since the melting point of the second metal layer is higher than the melting point of the solder layer, only the solder layer can be melted without melting the second metal layer when the air cavity is formed.

An absolute value of a difference between the melting point of the solder layer and the melting point of the second metal layer is more than 0°C, preferably 5°C or more, more preferably 10°C or more, still more preferably 30°C or more, particularly preferably 50°C or more, most preferably 100°C or more.

The second metal layer includes a metal. The metal constituting the second metal layer is not particularly limited. Examples of the metal include gold, silver, copper, platinum, palladium, zinc, lead, aluminum, cobalt, indium, nickel, chromium, titanium, antimony, bismuth, germanium, cadmium, and alloys of these. As the metal, tin-doped indium oxide (ITO) may be used. One kind of the metal may be used alone, and two or more kinds thereof may be used in combination.

The second metal layer is preferably a nickel layer, a palladium layer, a copper layer, or a gold layer, more preferably a nickel layer, a gold layer, or a copper layer, and still more preferably a copper layer. The metal particle preferably has a nickel layer, a palladium layer, a copper layer, or a gold layer, more preferably a nickel layer, a gold layer, or a copper layer, and still more preferably a copper layer. By bonding the two substrates using a bonding material containing metal particles having these preferable metal layers, the gap of the air cavity can be controlled with higher accuracy. Additionally, on the surfaces of these preferable metal layers, a solder layer can be more easily formed.

The thickness of the metal layer is preferably 3.5 $\mu$m or more, more preferably 8 $\mu$m or more, and preferably 80 $\mu$m or less, more preferably 65 $\mu$m or less, still more preferably 50 $\mu$m or less. When the thickness of the metal layer is equal to or more than the above lower limit and equal to or less than the above upper limit, the bonding strength between the substrates can be further enhanced.

The thickness of the second metal layer is preferably 0.5 $\mu$m or more, more preferably 3 $\mu$m or more, and preferably 30 $\mu$m or less, more preferably 25 $\mu$m or less, still more preferably 20 $\mu$m or less. When the thickness of the second metal layer is equal to or more than the above lower limit and equal to or less than the above upper limit, the bonding strength between the substrates can be further enhanced.

The thickness of the solder layer (first metal layer) is preferably 3 $\mu$m or more, more preferably 5 $\mu$m or more, and preferably 50 $\mu$m or less, more preferably 40 $\mu$m or less, still more preferably 30 $\mu$m or less. When the thickness of the solder layer is equal to or more than the above lower limit and equal to or less than the above upper limit, the bonding strength between the substrates can be further enhanced.

The thickness of the metal layer, the thickness of the second metal layer, and the thickness of the solder layer can be measured, for example, by observing a cross section of the metal particle using a transmission electron microscope (TEM).

A method of forming the metal layer on the surface of the base particle is not particularly limited. Examples of the method of forming the metal layer include a method by electroless plating, a method by electroplating, a method by physical collision, a method by mechanochemical reaction, a method by physical vapor deposition or physical adsorption, and a method of coating paste containing a metal powder or paste containing a metal powder and a binder on the surface of the base particle. The method of forming the metal layer is preferably the method by electroless plating, electroplating, or physical collision. Examples of the method by physical vapor deposition include methods of vacuum deposition, ion plating, ion sputtering and the like. In the method by physical collision, for example, Theta Composer (manufacture by TOKUJU Co., LTD) or the like is used.

(Antenna device)

The antenna device according to the present invention includes a first substrate having a first metal portion on its surface, a second substrate having a second metal portion on its surface, and a bonding material portion that bonds the first substrate and the second substrate. In the antenna device according to the present invention, the material of the bonding material portion is the above-described bonding material. In the antenna device according to the present invention, the first metal portion and the second metal portion are bonded by the bonding material portion. In the antenna device according to the present invention, an air cavity is formed by the first substrate, the second substrate, and the bonding material portion.

The first substrate is preferably a glass epoxy substrate or a ceramic substrate. The second substrate is preferably a glass epoxy substrate, a ceramic substrate, or a silicon substrate. The substrate may be a high frequency substrate, a substrate constituting an antenna, or the like. The first metal portion is preferably formed of copper or formed by nickel/gold plating. The second metal portion is preferably formed of copper or formed by nickel/gold plating. The first metal portion and the second metal portion may be formed of copper or formed by nickel/gold plating.

Fig. 3 is a cross-sectional view showing an example of an antenna device using the bonding material according to the present invention.

An antenna device 11 shown in Fig. 3 includes a first substrate 12, a second substrate 13, and a bonding material portion that bonds the first substrate 12 and the second substrate 13. The material of the bonding material portion is the bonding material described above. In the present embodiment, the material of the bonding material portion is the metal particle 1. The bonding material portion is preferably formed of the metal particles.

The first substrate 12 has a plurality of first metal portions 12a on its surface (upper surface). The second substrate 13 has a plurality of second metal portions 13a on its surface (lower surface). The first metal portion 12a and the second metal portion 13a are bonded by one or the plurality of metal particles 1 (bonding material portion). In the antenna device 11, an air cavity 14 is formed by the first substrate 12, the second substrate 13, and the metal particle 1 (bonding material portion). An interval (gap) between the first substrate 12 and the second substrate 13 is kept constant by the metal particle 1 (bonding material portion). A gap of the air cavity 14 is controlled by the metal particle 1 (bonding material portion).

The gap in the antenna device may be set according to a frequency band targeted by the antenna device.

A method of producing the antenna device is not particularly limited. An example of the method of producing the antenna device includes a method in which the bonding material described above is disposed between the first metal portion and the second metal portion to obtain a laminate, and then the laminate is heated and pressurized. The pressurization pressure is about $9.8 \times 10^4$ Pa to $4.9 \times 10^6$ Pa. The heating temperature is about 120°C to 250°C. From the viewpoint of controlling the gap of the air cavity with higher accuracy, it is preferable not to apply pressure at the time of manufacturing the antenna device. Since the molten solder layer of the metal particle is not excessively wetted and spread on the first metal portion and the second metal portion by not applying pressure at the time of manufacturing the antenna device, the gap of the air cavity can be controlled with higher accuracy.

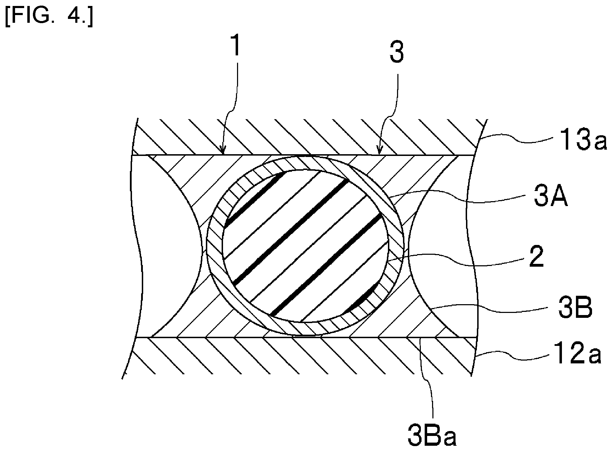

Fig. 4 is an enlarged cross-sectional view showing a bonding portion between the metal particle and the metal portion in the antenna device shown in Fig. 3.

As shown in Fig. 4, in the antenna device 11, the solder layer 3B of the metal particle 1 is melted by heating the laminate, and then a melted solder layer portion 3Ba sufficiently comes into contact with the first metal portion 12a and the second metal portion 13a. By using the metal particle 1 in which the outermost layer is a solder layer, a contact area between the metal particle 1 and the first and second metal portions 12a and 13a can be increased as compared with the case of using the metal particle in which the outermost layer is a metal such as nickel, gold, or copper, and the gap of the air cavity can be controlled with higher accuracy. In addition, by using the metal particle 1 that is not the solder particle formed of solder, excessive wetting and spreading of the solder due to heating can be suppressed even in the case of repeated heating, and the gap of the air cavity can be controlled with higher accuracy, as compared with the case of using a solder particle in which both the center portion and the outer surface portion of the metal layer are formed of solder.

The present invention will be specifically described below by way of Examples and Comparative Examples. The present invention is not limited only to the following Examples.

(Metal particle 1)

Divinylbenzene (50 parts by weight) and tetramethylolmethane tetraacrylate (50 parts by weight) were copolymerized to prepare base particles (average particle diameter 240 μm, CV value 1.85%) as resin particles. The obtained base particles were subjected to electroless nickel plating to form an underlying nickel plating layer having a thickness of 0.3 μm on the surface of the base particles. Next, the base particle on which the underlying nickel plating layer was formed was subjected to electrolytic copper plating to form a copper layer having a thickness of 10 μm. In addition, electrolytic plating was performed to form a solder layer containing tin having a thickness of 25 μm. In this way, the metal particles 1 (average particle diameter 310 μm, CV value 2.85%) in which a copper layer having a thickness of 10 μm was formed on the surface of the base particle and a solder layer (tin : silver = 96.5% by weight : 3.5% by weight) having a thickness of 25 μm was formed on the surface of the copper layer were prepared.

(Metal particle 2)

Base particles (average particle size 260 $\mu$m, CV value 1.92%) as resin particles were prepared in the same manner as in the metal particles 1. The obtained base particles were subjected to electroless nickel plating to form an underlying nickel plating layer having a thickness of 0.3 $\mu$m on the surface of the base particles. Next, the base particle on which the underlying nickel plating layer was formed was subjected to electrolytic copper plating to form a copper layer having a thickness of 5 $\mu$m. In addition, electrolytic plating was performed to form a solder layer containing tin having a thickness of 20 $\mu$m. In this way, the metal particles 2 (average particle diameter 310 $\mu$m, CV value 2.76%) in which a copper layer having a thickness of 5 $\mu$m was formed on the surface of the base particle and a solder layer (tin : silver = 96.5% by weight : 3.5% by weight) having a thickness of 20 $\mu$m was formed on the surface of the copper layer were prepared.

(Metal particle 3)

Base particles (average particle size 210 $\mu$m, CV value 1.68%) as resin particles were prepared in the same manner as in the metal particles 1. The obtained base particles were subjected to electroless nickel plating to form an underlying nickel plating layer having a thickness of 0.3 $\mu$m on the surface of the base particles. Next, the base particle on which the underlying nickel plating layer was formed was subjected to electrolytic copper plating to form a copper layer having a thickness of 10 $\mu$m. In addition, electrolytic plating was performed to form a solder layer containing tin having a thickness of 40 $\mu$m. In this way, the metal particles 3 (average particle diameter 310 $\mu$m, CV value 3.21%) in which a copper layer having a thickness of 10 $\mu$m was formed on the surface of the base particle and a solder layer (tin : silver = 96.5% by weight : 3.5% by weight) having a thickness of 40 $\mu$m was formed on the surface of the copper layer were prepared.

(Metal particle X1)

A solder ball ("M 705" manufactured by Senju Metal Industry Co., Ltd., tin : silver : copper = 96.5% by weight : 3% by weight : 0.5% by weight) formed of solder containing tin, silver, and copper was used as metal particles X1 (average particle diameter 300 $\mu$m).

(Average particle diameter of metal particles)

The average particle diameter of the metal particles was measured by the method described above using a digital microscope ("VHX-5000" manufactured by KEYENCE CORPORATION).

(Example 1)

The obtained metal particles 1 themselves were used as a bonding material without using a bonding component other than the metal particles 1.

(Preparation of antenna device A)

As the first substrate, a glass epoxy substrate having 20 metal portions (first metal portions) formed of copper was prepared. As the second substrate, a glass epoxy substrate having 20 metal portions (second metal portions) formed of copper was prepared. The metal portion is a metal portion for forming an antenna circuit. A flux ("WS-9160-M7" manufactured by Cookson Electronics) was applied onto the surface of the first metal portion of the first substrate. Subsequently, the metal particles 1 were arranged on the surface of the applied flux, and reflow treatment (heating temperature 250°C and heating time 30 seconds) was performed to bond the metal particles 1 to the first metal portion. Next, a solder paste ("M705-GRN360-K2-V" manufactured by Senju Metal Industry Co., Ltd.) was applied onto the surface of the second metal portion of the second substrate. A bonding structure of the first substrate and the metal particles 1 and the second substrate to which the solder paste was applied were arranged so that the first metal portion and the second metal portion faced each other, and reflow treatment (heating temperature 250°C and heating time 30 seconds) was performed. In this way, an antenna device A in which the first metal portion and the second metal portion were bonded via a bonding portion formed of the metal particles 1 was prepared.

(Preparation of antenna device B)

An antenna device B was prepared in the same manner as in the method of preparing the antenna device A except that a glass epoxy substrate having 20 metal portions (second metal portions) formed by nickel/gold plating was used as the second substrate.

(Preparation of antenna device C)

An antenna device C was prepared in the same manner as in the method of preparing the antenna device A except that a glass epoxy substrate having 20 metal portions (second metal portions) formed by nickel/gold plating was used as the first and second substrates.

(Example 2)

The antenna devices A, B, and C were prepared in the same manner as in Example 1 except that the metal particles 2 were used as a bonding material instead of the metal particles 1.

(Example 3)

The antenna devices A, B, and C were prepared in the same manner as in Example 1 except that the metal particles 3 were used as a bonding material instead of the metal particles 1.

(Comparative Example 1)

The antenna devices A, B, and C were prepared in the same manner as in Example 1 except that the metal particles X1 were used as a bonding material instead of the metal particles 1.

(Evaluation)

(1) Rate of change in gap between substrates (Evaluation Test 1a)

(1-1) The obtained metal particles (bonding material) were provided. In addition, a first substrate (glass epoxy substrate) having a first metal portion formed of copper on its surface was provided. A second substrate (glass epoxy substrate) having a second metal portion formed of copper on its surface was provided. Using the provided metal particles (bonding material), the first substrate, and the second substrate, the rate of change in gap between the substrates was calculated by the method described above.

(1-2) The obtained metal particles (bonding material) were provided. In addition, a first substrate (glass epoxy substrate) having a first metal portion formed of copper on its surface was provided. A second substrate (glass epoxy substrate) having a second metal portion formed by nickel/gold plating on its surface was provided. Using the provided metal particles (bonding material), the first substrate, and the second substrate, the rate of change in gap between the substrates was calculated by the method described above.

(1-3) The obtained metal particles (bonding material) were provided. A first substrate (glass epoxy substrate) having a first metal portion formed by nickel/gold plating on its surface was provided. A second substrate (glass epoxy substrate) having a second metal portion formed by nickel/gold plating on its surface was provided. Using the provided metal particles (bonding material), the first substrate, and the second substrate, the rate of change in gap between the substrates was calculated by the method described above.

[Criteria for judgment in rate of change in gap between substrates]

○: The rate of change in gap is 10% or less.
×: The rate of change in gap is more than 10%.

(2) Ratio (gap after heating/average particle diameter of metal particles) (Evaluation Test 1b)

(2-1) The obtained metal particles (bonding material) were provided. In addition, a first substrate (glass epoxy substrate) having a first metal portion formed of copper on its surface was provided. A second substrate (glass epoxy substrate) having a second metal portion formed of copper on its surface was provided. Using the provided metal particles (bonding material), the first substrate, and the second substrate, the ratio (the gap after heating/the average particle diameter of the metal particles) was calculated by the method described above.

(2-2) The obtained metal particles (bonding material) were provided. In addition, a first substrate (glass epoxy substrate) having a first metal portion formed of copper on its surface was provided. A second substrate (glass epoxy substrate) having a second metal portion formed by nickel/gold plating on its surface was provided. Using the provided metal particles (bonding material), the first substrate, and the second substrate, the ratio (the gap after heating/the average particle diameter of the metal particles) was calculated by the method described above.

(2-3) The obtained metal particles (bonding material) were provided. A first substrate (glass epoxy substrate) having a first metal portion formed by nickel/gold plating on its surface was provided. A second substrate (glass epoxy substrate) having a second metal portion formed by nickel/gold plating on its surface was provided. Using the provided metal particles (bonding material), the first substrate, and the second substrate, the ratio (the gap after heating/the average particle diameter of the metal particles) was calculated by the method described above.

[Criteria for judgment in ratio (gap after heating/average particle diameter of metal particles)]

∘: The ratio (the gap after heating/the average particle diameter of the metal particles) is 0.70 or more and 0.97 or less
×: The ratio (the gap after heating/the average particle diameter of the metal particles) is less than 0.70 or more than 0.97.

(3) Rate of change in bonding strength between substrates (Evaluation Test 2)

(3-1) The obtained metal particles (bonding material) were provided. In addition, a first substrate (glass epoxy substrate) having a first metal portion formed of copper on its surface was provided. A second substrate (glass epoxy substrate) having a second metal portion formed of copper on its surface was provided. Using the provided metal particles (bonding material), the first substrate, and the second substrate, the rate of change in bonding strength between the substrates was calculated by the method described above.

(3-2) The obtained metal particles (bonding material) were provided. In addition, a first substrate (glass epoxy substrate) having a first metal portion formed of copper on its surface was provided. A second substrate (glass epoxy substrate) having a second metal portion formed by nickel/gold plating on its surface was provided. Using the provided metal particles (bonding material), the first substrate, and the second substrate, the rate of change in bonding strength between the substrates was calculated by the method described above.

(3-3) The obtained metal particles (bonding material) were provided. A first substrate (glass epoxy substrate) having a first metal portion formed by nickel/gold plating on its surface was provided. A second substrate (glass epoxy substrate) having a second metal portion formed by nickel/gold plating on its surface was provided. Using the provided metal particles (bonding material), the first substrate, and the second substrate, the rate of change in bonding strength between the substrates was calculated by the method described above.

[Criteria for judgment in rate of change in bonding strength between substrates]

∘: The rate of change in bonding strength is 10% or less.
×: The rate of change in bonding strength is more than 10%.

(4) Gap controllability

The thickness of the air cavity of each of the five antenna devices A obtained was measured using a stereoscopic microscope ("SMZ-10" manufactured by Nikon Corporation), and an average thickness of the air cavity in each of the five antenna devices A was calculated. From a difference between a maximum value of the average thickness and a minimum value of the average thickness, gap controllability was determined according to the following criteria. The obtained antenna devices B and C were also evaluated in the same manner.

[Criteria for judgment in gap controllability]

∘: The difference between the maximum value of the average thickness of the air cavity and the minimum value of the average thickness is less than 10 μm.

×: The difference between the maximum value of the average thickness of the air cavity and the minimum value of the average thickness is 10 μm or more.

(5) Gap controllability after reflow treatment

Using the five antenna devices A after the evaluation of (4) Gap controllability, reflow treatment was performed four times under the reflow conditions specified in JEDEC J-STD-020. The antenna device A after reflow treatment was evaluated in the same manner as in (4) Gap controllability. The gap controllability after reflow treatment was determined according to the following criteria. The obtained antenna devices B and C were also evaluated in the same manner.

[Criteria for judgment in gap controllability after reflow treatment]

∘: The difference between the maximum value of the average thickness of the air cavity and the minimum value of the average thickness is less than 10 μm.
×: The difference between the maximum value of the average thickness of the air cavity and the minimum value of the average thickness is 10 μm or more.

(6) Antenna communication quality

Whether or not the antenna operates with high accuracy was confirmed using the antenna device A after the evaluation of (5) Gap controllability after reflow treatment. The communication quality of the antenna was judged according to the following criteria. The obtained antenna devices B and C were also evaluated in the same manner.

[Criteria for judgment in communication quality of antenna]

∘: The antenna device operates stably without variation.
×: The operation of the antenna device varies.

The results are shown in the following Table 1.

[Table 1]

**Antenna device A**

| | Average particle diameter of metal particles (μm) | Gap (μm) Before heating | Gap (μm) After heating | Rate of change in gap (Evaluation Test 1a) | Ratio (gap after heating/average particle diameter of metal particles) (Evaluation Test 1b) | Bonding strength (kgf) Before heating | Bonding strength (kgf) After heating | Rate of change in bonding strength (Evaluation Test 2) | Gap controllability | Gap controllability after reflow | Antenna communication quality |
|---|---|---|---|---|---|---|---|---|---|---|---|
| Example 1 | 310 | 267.2 | 265.8 | 0.5% ○ | 0.857 ○ | 3.51 | 3.31 | 5.7% ○ | ○ | ○ | ○ |
| Example 2 | 310 | 278.4 | 275.9 | 0.9% ○ | 0.890 ○ | 2.89 | 2.77 | 4.2% ○ | ○ | ○ | ○ |
| Example 3 | 310 | 241.8 | 235.9 | 2.4% ○ | 0.761 ○ | 4.92 | 4.59 | 6.7% ○ | ○ | ○ | ○ |
| Comparative Example 1 | 300 | 188.5 | 165.8 | 12.18 × | 0.553 × | 7.28 | 6.39 | 12.28 × | × | × | × |

**Antenna device B**

| | Average particle diameter of metal particles (μm) | Gap (μm) Before heating | Gap (μm) After heating | Rate of change in gap (Evaluation Test 1a) | Ratio (gap after heating/average particle diameter of metal particles) (Evaluation Test 1b) | Bonding strength (kgf) Before heating | Bonding strength (kgf) After heating | Rate of change in bonding strength (Evaluation Test 2) | Gap controllability | Gap controllability after reflow | Antenna communication quality |
|---|---|---|---|---|---|---|---|---|---|---|---|
| Example 1 | 310 | 268.3 | 264.8 | 1.3% ○ | 0.854 ○ | 3.54 | 3.33 | 5.9% ○ | ○ | ○ | ○ |
| Example 2 | 310 | 278.9 | 275.3 | 1.3% ○ | 0.888 ○ | 2.91 | 2.67 | 8.2% ○ | ○ | ○ | ○ |
| Example 3 | 310 | 242.5 | 234.9 | 3.1% ○ | 0.758 ○ | 5.08 | 4.76 | 6.3% ○ | ○ | ○ | ○ |
| Comparative Example 1 | 300 | 189.2 | 168.8 | 10.88 × | 0.563 × | 7.42 | 6.61 | 10.98 × | × | × | × |

EP 4 032 960 A1

(continued)

| Antenna device C | | | | | | | | | | | | | |
|---|---|---|---|---|---|---|---|---|---|---|---|---|---|
| | Average particle diameter of metal particles (μm) | Gap (μm) | | Rate of change in gap (Evaluation Test 1a) | | Ratio (gap after heating/ average particle diameter of metal particles) (Evaluation Test 1b) | | Bonding strength (kef) | | Rate of change in bonding strength (Evaluation Test 2) | | Gap controllability | Gap controllability after reflow | Antenna communication quality |
| | | Before heating | After heating | | | | | Before heating | After heating | | | | | |
| Example 1 | 310 | 266.9 | 264.8 | 0.8% | ○ | 0.854 | ○ | 3.55 | 3.33 | 6.2% | ○ | ○ | ○ | ○ |
| Example 2 | 310 | 279.2 | 274.9 | 1.5% | ○ | 0.887 | ○ | 2.96 | 2.73 | 7.8% | ○ | ○ | ○ | ○ |
| Example 3 | 310 | 242.5 | 236.9 | 2.3% | ○ | 0.764 | ○ | 5.16 | 4.68 | 9.3% | ○ | ○ | ○ | ○ |
| Comparative Example 1 | 300 | 190.2 | 168.8 | 11.3% | × | 0.563 | × | 7.43 | 6.67 | 10.2% | × | × | × | × |

The same tendency was observed even when a ceramic substrate or a silicon substrate was used as the first substrate and the second substrate instead of the glass epoxy substrate.

EXPLANATION OF SYMBOLS

1, 1A: Metal particle
2: Base particle
3: Metal layer
3A: Second metal layer
3B: Solder layer (first metal layer)
3Ba: Melted solder layer portion
4: Solder layer
11: Antenna device
12: First substrate
12a: First metal portion
13: Second substrate
13a: Second metal portion
14: Air cavity

**Claims**

1. A bonding material for bonding a first metal portion and a second metal portion to each other between a first substrate having the first metal portion on its surface and a second substrate having the second metal portion on its surface,

   a rate of change in gap between the substrates calculated by the following Evaluation Test 1a being 10% or less, Evaluation Test 1a:
   the first substrate having the first metal portion on the surface, the second substrate having the second metal portion on the surface, and the bonding material are provided, the bonding material is disposed on the first metal portion of the first substrate, the second substrate is disposed on a surface of the bonding material opposite to a side of the first substrate in such a way that the first metal portion and the second metal portion face each other, thereafter, the first substrate and the second substrate are bonded to each other by performing reflow treatment under reflow conditions defined in JEDEC J-STD-020 to obtain a laminate, the gap between the substrates of the obtained laminate is measured and taken as the gap before heating, thereafter, the obtained laminate is subjected to reflow treatment four times under reflow conditions defined in JEDEC J-STD-020, the gap between the substrates of the laminate after reflow treatment is measured and taken as the gap after heating, and from the gaps before and after heating, the rate of change in gap is calculated by the following Equation (1):

$$\text{Rate of Change in Gap} = [(\text{Gap before Heating} - \text{Gap after Heating})/\text{Gap before Heating}] \times 100 \quad \text{Equation (1)}.$$

2. The bonding material according to claim 1, comprising a metal particle.

3. A bonding material for bonding a first metal portion and a second metal portion to each other between a first substrate having the first metal portion on its surface and a second substrate having the second metal portion on its surface,

   the bonding material containing metal particles, and
   a ratio of a gap after heating calculated by the following Evaluation Test 1b to an average particle diameter of the metal particles being 0.70 or more and 0.97 or less,
   Evaluation Test 1b:
   the first substrate having the first metal portion on the surface, the second substrate having the second metal portion on the surface, and the bonding material are provided, the bonding material is disposed on the first metal portion of the first substrate, the second substrate is disposed on a surface of the bonding material opposite to a side of the first substrate in such a way that the first metal portion and the second metal portion face each other, thereafter, the first substrate and the second substrate are bonded to each other by performing reflow treatment under reflow conditions defined in JEDEC J-STD-020 to obtain a laminate, and the obtained laminate is subjected to reflow treatment four times under reflow conditions defined in JEDEC J-STD-020, and the gap between the substrates of the laminate after reflow treatment is measured and taken as the gap after heating.

4.  The bonding material according to claim 2 or 3, wherein the metal particle includes a base particle and a metal layer disposed on a surface of the base particle.

5.  The bonding material according to claim 4, wherein

    the metal layer includes a second metal layer disposed on a surface of the base particle and a first metal layer disposed on a surface of the second metal layer, and
    the first metal layer is a solder layer.

6.  The bonding material according to any one of claims 1 to 5, wherein

    a rate of change in bonding strength between the substrates calculated by the following Evaluation Test 2 is 10% or less,
    Evaluation Test 2:
    the first substrate having the first metal portion on the surface, the second substrate having the second metal portion on the surface, and the bonding material are provided, the bonding material is disposed on the first metal portion of the first substrate, the second substrate is disposed on a surface of the bonding material opposite to a side of the first substrate in such a way that the first metal portion and the second metal portion face each other, thereafter, the first substrate and the second substrate are bonded to each other by performing reflow treatment under reflow conditions defined in JEDEC J-STD-020 to obtain a laminate, and using the obtained laminate, the bonding strength between the substrates is measured under conditions conforming to MIL STD-883G, and taken as the bonding strength before heating, thereafter, the obtained laminate is subjected to reflow treatment four times under reflow conditions defined in JEDEC J-STD-020, the bonding strength between the substrates is measured using the laminate after reflow treatment under conditions conforming to MIL STD-883G, and taken as the bonding strength after heating, and from the bonding strength before and after heating, the rate of change in bonding strength is calculated by the following Equation (2):

    Rate of Change in Bonding Strength = [(Bonding Strength before Heating − Bonding Strength after Heating)/Bonding Strength before Heating] × 100   Equation (2).

7.  The bonding material according to any one of claims 1 to 6, wherein the first substrate is a glass epoxy substrate or a ceramic substrate, and the second substrate is a glass epoxy substrate, a ceramic substrate, or a silicon substrate.

8.  The bonding material according to any one of claims 1 to 7, wherein

    the first metal portion is formed of copper or formed by nickel/gold plating, and
    the second metal portion is formed of copper or formed by nickel/gold plating.

9.  An antenna device comprising:

    a first substrate having a first metal portion on its surface;
    a second substrate having a second metal portion on its surface; and
    a bonding material portion that bonds the first substrate and the second substrate to each other,
    a material of the bonding material portion being the bonding material according to any one of claims 1 to 8,
    the first metal portion and the second metal portion being bonded to each other by the bonding material portion, and

an air cavity being formed by the first substrate, the second substrate, and the bonding material portion.

**10.** The antenna device according to claim 9, wherein

the first substrate is a glass epoxy substrate or a ceramic substrate, and
the second substrate is a glass epoxy substrate, a ceramic substrate, or a silicon substrate.

**11.** The antenna device according to claim 9 or 10, wherein

the first metal portion is formed of copper or formed by nickel/gold plating, and
the second metal portion is formed of copper or formed by nickel/gold plating.

[FIG. 1.]

[FIG. 2.]

[FIG. 3.]

[FIG. 4.]

**INTERNATIONAL SEARCH REPORT**

| International application No. |
| --- |
| PCT/JP2020/033932 |

A. CLASSIFICATION OF SUBJECT MATTER
C09J 1/00(2006.01)i; C09J 9/02(2006.01)i; C22C 13/00(2006.01)i; C22C 13/02(2006.01)i; B23K 35/14(2006.01)i; B23K 35/26(2006.01)i; H05K 1/14(2006.01)i; H05K 3/34(2006.01)i; H05K 3/36(2006.01)i
FI: C09J1/00; B23K35/14 Z; H05K3/34 505Z; H05K3/34 507H; H05K3/36 B; H05K1/14 A; B23K35/26 310A; C22C13/00; C22C13/02; C09J9/02
According to International Patent Classification (IPC) or to both national classification and IPC

B. FIELDS SEARCHED

Minimum documentation searched (classification system followed by classification symbols)
C09J1/00; C09J9/02; C22C13/00; C22C13/02; B23K35/14; B23K35/26; H05K1/14; H05K3/34; H05K3/36

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | WO 98/46811 A1 (SEKISUI FINE CHEMICAL CO., LTD.) 22 October 1998 (1998-10-22) claims 27-61, page 7, line 8 to page 10, line 2, page 53, line 20 to page 62, line 10, examples 59-62, fig. 40, 43-45 | 1-8<br>9-11 |
| Y | WO 2010/026990 A1 (MITSUBISHI ELECTRIC CORP.) 11 March 2010 (2010-03-11) claims 1-11, paragraphs [0012]-[0041], fig. 1-2, 4 | 9-11 |

☐ Further documents are listed in the continuation of Box C.  ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 November 2020 (04.11.2020) | 24 November 2020 (24.11.2020) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

INTERNATIONAL SEARCH REPORT

Information on patent family members

International application No.

PCT/JP2020/033932

| Patent Documents referred in the Report | Publication Date | Patent Family | Publication Date |
|---|---|---|---|
| WO 98/46811 A1 | 22 Oct. 1998 | US 2006/0286369 A1 claims 1-7, fig. 40, 43-45, paragraphs [0037]-[0050], [0382]-[0428], examples 59-68 US 6562217 B1 US 2003/0178313 A1 EP 1010781 A1 KR 10-0574215 B1 KR 10-2005-0084536 A KR 10-2005-0084537 A KR 10-2005-0084538 A JP 11-172495 A US 2004/0031690 A1 | |
| WO 2010/026990 A1 | 11 Mar. 2010 | US 2011/0163919 A1 claims 12-22, fig. 1, 2, 4, paragraphs [0017]-[0052] US 2011/0175793 A1 US 2015/0257254 A1 EP 2333828 A1 EP 3598484 A1 CN 102144289 A JP 2011-155287 A JP 2013-165273 A JP 2014-187369 A JP 2015-167422 A JP 2016-197882 A | |

Form PCT/ISA/210 (patent family annex) (January 2015)

**EP 4 032 960 A1**

**Patent documents cited in the description**

- JP 2015185550 A